# EUROPEAN PATENT APPLICATION

(11) **EP 1 347 468 A1**
(43) Date of publication of application: **24.09.2003**
(21) Application number: 01272538.8
(22) Date of filing: 26.12.2001
(51) Int. Cl.: H01B 13/00, G02F 1/1343, G03F 7/004

(54) **METHOD FOR PATTERNING ELECTROCONDUCTIVE TIN OXIDE FILM**

(30) Priority: 28.12.2000 JP 2000400431
(71) Applicant: Nissan Chemical Industries, Ltd., Chiyoda-ku, Tokyo 101-0054 (JP)
(72) Inventor: WAKABAYASHI,M Nissan Chem.Ind.Ltd. Elec.Mat.Res.Lb, Funabashi-shi, Chiba 274-8507 (JP); MOTOYAMA,K. Nissan Chem.Ind.Ltd. Elec.Mat.Res.Lab., Funabashi-shi, Chiba 274-8507 (JP); FURUSHO,H. Nissan Chem.Ind.Ltd. Elec.Mat.Res.Lab., Funabashi-shi, Chiba 274-8507 (JP); FUKURO,H. Nissan Chem.Ind.Ltd. elec.Mat.Res.Lab., Funabashi-shi, Chiba 274-8507 (JP)
(74) Representative: Hartz, Nikolai F., Dr.
(86) International application number: JP0111485
(87) International publication number: WO02054416

(57) **Abstract**

A method for obtaining an electroconductive tin oxide pattern film simply and efficiently without using a resist film. A method for patterning an electroconductive tin oxide film, characterized by employing a solution having a tin compound and a dopant compound soluble in an organic solvent dissolved in the organic solvent, drying it to such an extent that the dried film retains the solubility in a developing solution, exposing the dried film with a light containing an ultraviolet region to render it partially insoluble, and etching the unexposed portion with the developing solution.

## Description

### TECHNICAL FIELD

The present invention relates to a method for patterning an electroconductive tin oxide film to be used for e.g. a touch panel, a plasma display panel, a liquid crystal display or a solar cell which requires transparent display electrodes.

### BACKGROUND ART

In recent years, along with a rapid progress in wide spread use of computers, touch panels have become important as simpler data input devices, and liquid crystal displays, plasma display panels and EL displays are expected as novel display devices to be substituted for CRT. Such devices employing transparent electrodes are used in various fields, and their market is expected to further expand because of their industrial usefulness.

As the transparent electrode materials, indium(III) oxide having tin oxide doped, and tin(IV) oxide having antimony doped, are typical. A tin(IV) oxide type electroconductive material has excellent characteristics such that as compared with an indium(III) oxide type, the raw material is abundant and inexpensive, its heat resistance is high, and it is chemically stable. On the other hand, it has a problem such that etching is difficult, and it is thereby difficult to obtain a pattern with high precision. Accordingly, at present, indium(III) oxide type electroconductive materials which can be easily processed by etching, are mainly employed for the above-mentioned applications, and with respect to tin(IV) oxide type materials, patterning is a technical problem to be solved.

Various methods have been proposed as conventional patterning methods for tin(IV) oxide films.

JP-A-55-139714 discloses a method which comprises coating a photoresist on a thin film of tin(IV) oxide formed on a glass substrate to form a photoresist pattern, coating a zinc powder over the entire surface to contact it with the tin(IV) oxide film at portions where no photoresist is present, followed by immersion in a mixed aqueous solution of hydrochloric acid and phosphoric acid to remove the tin(IV) oxide film, and further removing the photoresist, to form the desired tin(IV) oxide thin film pattern.

JP-A-57-136705 discloses a method which comprises forming a tin(IV) oxide film on a substrate, coating a photoresist thereon to form a photoresist pattern, exposing it in a hydrogen plasma in a state maintained to be at least 100°C, to reduce the portions having no photoresist formed, to metal tin, dissolving the reduced portions by hydrochloric acid, and peeling the mask pattern, thereby to obtain a tin(IV) oxide thin film pattern.

JP-A-2-234310 discloses a method which comprises spraying an aqueous solution of tin tetrachloride and sulfuric acid to a substrate heated to 400°C, to form tin(II) sulfide on the substrate, coating a photoresist after returning the temperature to room temperature, to form a pattern, etching the tin(II) sulfide film at portions where no photoresist is formed, with an aqueous sodium hydroxide solution, removing the photoresist, and then, finally carrying out baking to obtain a patterned tin(IV) oxide film.

JP-A-11-111082 discloses a method for patterning an electroconductive tin oxide film, which is characterized by coating a solution having a tin compound and a dopant compound dissolved therein, on a substrate, drying a coating film formed on the substrate, to form a dried film, forming a resist thereon, developing the resist partially to form a pattern, etching the lower layer dried film, then peeling the non-developed resist, and baking the lower layer dried film to obtain a tin (IV) oxide film, wherein a solution having a tin compound and a dopant compound soluble in an organic solvent dissolved in the organic solvent, is employed, and it is dried to such an extent that the dried film retains the solubility in a developing solution, and the resist and the dried film are simultaneously subjected to etching with a developing solution.

The method disclosed in JP-A-55-139714 has a problem such that the reaction of the zinc powder with hydrochloric acid takes place rapidly, whereby it is difficult to control dissolution of the tin(IV) oxide film which proceeds at the same time as the reaction, and if the dissolution rate is high, the tin(IV) oxide beneath the resist layer tends to be dissolved, and if the dissolution rate is low, a residual film tends to remain.

In the method disclosed in JP-A-57-136705, hydrogen plasma is employed in order to reduce tin(IV) oxide, whereby a vacuum-system apparatus is required, and the method is not efficient, as the productivity is poor. Further, there is a problem such that the photoresist will be chipped off by plasma, whereby a good pattern can not be obtained. Further, since a strong acid is used for the dissolution of metallic tin (Sn), a trouble such as a damage to the tin(IV) oxide film or a necessity to increase a process step, is likely to result.

The method disclosed in JP-A-2-234310 is not efficient, since it is necessary to employ a special spraying apparatus to form tin(II) sulfide. Further, the process steps will increase and become cumbersome, since after the patterning of the photoresist, the tin(II) sulfide film is subjected again to etching with sodium hydroxide.

In the method disclosed in JP-A-11-111082, the process is simplified by etching the resist and the dried film simultaneously with the developing solution. However, so long as the resist is to be employed, a step of peeling an undeveloped resist is still required.

It is an object of the present invention to solve the above-mentioned problems and to provide a method for obtaining an electroconductive tin(IV) oxide pattern film simply and efficiently without using a resist film.

### DISCLOSURE OF THE INVENTION

The present invention provides a method for patterning an electroconductive tin(IV) oxide film, characterized by employing a solution having a tin compound and a dopant compound soluble in an organic solvent dissolved in the organic solvent, drying it to such an extent that the dried film retains the solubility in a developing solution, exposing the dried film with a light containing an ultraviolet region to render it partially insoluble, and etching the unexposed portion with the developing solution.

And, the method for patterning an electroconductive tin oxide film of the present invention preferably comprises the following steps (A), (B) and (C):
(A) a step of forming the solution having a tin compound and a dopant compound soluble in an organic solvent dissolved in the organic solvent,
(B) a step of coating the solution obtained in step (A) on a substrate and drying a coating film formed on the substrate to form a dried film, and
(C) a step of transcribing a pattern on the dried film obtained in step (B), by a light containing an ultraviolet region, then etching the dried film constituting the transcribed pattern, with a developing solution to form a partially developed pattern film, and then baking the pattern film to form a tin(IV) oxide film.

Further, in the present invention, the method is preferably carried out in the following manner.

The above dopant compound is an antimony compound and/or a fluorine compound.

The above antimony compound is used in an atomic ratio of from 2 to 30 mol% based on the tin compound.

The above fluorine compound is used in an atomic ratio of from 2 to 60 mol% based on the tin compound.

In the present invention, the concentration of the tin compound and the dopant compound in the solution having them dissolved in the organic solvent, is from 2 to 30 wt% as solid content concentration.

As the light containing an ultraviolet region, a light containing a wavelength of from 180 nm to 400 nm, is used.

As the above developing solution, an alkaline developing solution or an acid developing solution is used.

The temperature for drying the coating film formed on the substrate is preferably within a range of from room temperature to 150°C, particularly preferably within a range of from 50 to 100°C.

The temperature for baking the pattern film is preferably at least 350°C.

### BRIEF DESCRIPTION OF THE DRAWINGS

Figs. 1 to 4 are stepwise cross-sectional views illustrating the patterning method of Example 1 for an electroconductive tin oxide film according to the present invention.
Fig. 1 is a cross-sectional view wherein a solution containing a tin compound is coated and dried on a substrate.
Fig. 2 is a cross-sectional view wherein exposure is conducted by irradiating ultraviolet rays via a pattern mask.
Fig. 3 is a cross-sectional view wherein the dried film at the unexposed portion is etched by an alkaline developing solution.
Fig. 4 is a cross-sectional view wherein a tin(IV) oxide film is formed by baking.

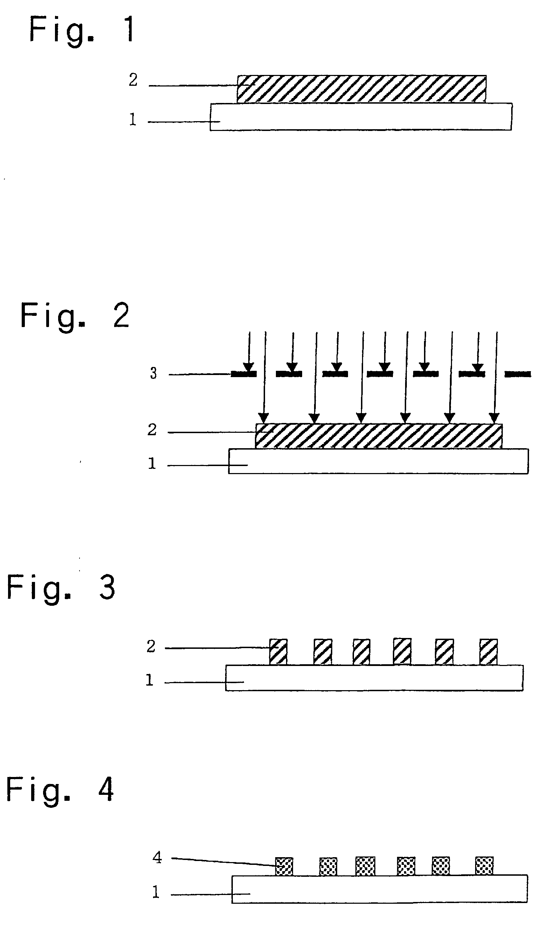

The symbols in Figs. 1 to 4 will be explained as follows.
1 ... Substrate
2 ... Pattern film containing a tin compound
3 ... Mask
4 ... Tin(IV) oxide film

### BEST MODE FOR CARRYING OUT THE INVENTION

The tin compound to be used in the present invention is not particularly limited, so long as it is one soluble in an organic solvent. As examples of the tin compound, one or more may be used among tin(II) chloride, tin(IV) chloride, tin(II) acetate, tin(II) octylate, tin tetraethoxide, monobutyltin trichloride, dibutyltin dichloride, butyldichlorotin acetate, butylchlorotin diacetate, dibutyldibutoxytin, dibutyltin oxide, etc.

As the dopant compound to be used in the present invention, it is preferred to employ an antimony compound and/or a fluorine compound for the purpose of improving the electroconductivity of the tin oxide film.

In a case where an antimony compound is used as a dopant, as examples of the antimony compound, one or more may be employed among antimony alkoxides such as antimony triethoxide and antimony tributoxide, inorganic salts such as antimony(III) nitrate, antimony(III) chloride and antimony(III) bromide, and organic salts such as antimony(III) acetate and antimony(III) butyrate.

The amount of the antimony compound to be added to the tin compound is preferably within a range of from 2 to 30 mol%, as a ratio of antimony atoms to tin atoms. If it is less than 2 mol% or in a range exceeding 30 mol%, the dopant effect by the addition of the antimony compound tends to be small, and a tin(IV) oxide film having an improved electroconductivity can hardly be obtainable, such being undesirable.

In a case where a fluorine compound is used as the dopant, as examples of the fluorine compound, it is preferred to employ one or more among hydrogen fluoride, ammonium fluoride, ammonium hydrogen fluoride, tin(II) fluoride, antimony(III) fluoride, boron fluoride, trifluoroacetic acid, trifluoroacetic anhydride, trifluoroethanol, ethyltrifluoroacetate, and pentafluoropropionic acid. Among them, it is particularly preferred to employ tin(IV) fluoride, since the handling is easy.

The amount of the fluorine compound to be added to the tin compound is preferably within a range of from 2 to 60 mol%, as a ratio of fluorine atoms to tin atoms. If it is less than 2 mol% or in a range exceeding 60 mol%, the dopant effect by the addition of the fluorine compound tends to be small, and a tin(IV) oxide film having an improved electroconductivity can hardly be obtained, such being undesirable.

The organic solvent to be used in the present invention, is not particularly limited so long as it is capable of dissolving the tin compound and the dopant compound and which is free from forming an impurity as a by-product which hinders the electroconductivity, such as an alkali metal or carbon, in the film after baking. As examples of the organic solvent, one or a combination of at least two may be employed among alcohols such as methanol, ethanol, isopropanol and butanol, ketones such as tetrahydrofuran, acetone, methyl ethyl ketone, acetyl acetone and cyclohexanone, glycols such as ethylene glycol, hexylene glycol, propylene glycol and 1,4-butandiol, glycol ethers such as ethylene glycol monomethyl ether, ethylene glycol monobutyl ether and propylene glycol monobutyl ether, and esters of organic acids, such as ethyl acetate, isopropyl acetate and butyl acetate.

In the present invention, the solution having a tin compound and a dopant compound dissolved in an organic solvent, is a uniform transparent solution containing no precipitate or gelled substance. The solid content of the tin compound and the dopant compound is calculated as the proportion of the weight of the nonvolatile oxide component to the total weight of the solution. The solid content concentration of the solution is suitably from 2 to 30 wt%, particularly preferably from 5 to 15 wt%. If the solid content concentration is lower than 2 wt%, no adequate thickness can be attained by single coating, and multilayers will be necessary, such being not efficient. If the solid content concentration is higher than 30 wt%, the film thickness tends to be too thick by single coating, whereby cracks are likely to form.

In the present invention, when the film dried to such an extent that it retains the solubility in a developing solution, is subjected to exposure with a light containing an ultraviolet region, oxidation of the tin compound in the dried film takes place, whereby the dried film at the exposed portion will be insolubilized selectively. With respect to the light containing an ultraviolet region, a light source containing a wavelength of from 180 nm to 400 nm, is preferred, since it is commercially sold and readily available.

The developing solution to be used in the present invention is one for etching of a dried film containing a tin compound. Accordingly, it is preferred to employ a solution of a basic compound or a solution of an acidic compound. The solution of a basic compound (the alkaline developing solution) may, for example, be an aqueous solution of e.g. a hydroxide, a silicate, a phosphate or an acetate of an alkali metal or quaternary ammonium, or an amine. Specifically, it may be an aqueous solution of e.g. sodium hydroxide, potassium hydroxide, ammonium hydroxide, trimethylbenzylammonium hydroxide, tetramethylammonium hydroxide, sodium silicate, sodium phosphate, sodium acetate, monoethanolamine, diethanolamine or triethanolamine. The solution of an acidic compound (the acid developing solution) is preferably an aqueous solution of an inorganic acid such as hydrochloric acid, nitric acid, sulfuric acid, hydrofluoric acid or phosphoric acid, or of an organic acid such as formic acid or acetic acid. However, the amount of the basic compound or the acidic compound to the amount of water is preferably such an amount that the difference in solubility between the exposed portion and the unexposed portion becomes sufficient.

In the present invention, the coating method for the solution is not particularly limited, and the solution can be coated on a substrate by a usual method such as a dipping method, a spin coating method, a brush coating method, a roll coating method, a flexo printing method or wire bar coating method.

The substrate to be used in the present invention is not particularly limited so long as it permits formation of an adhesive coating film thereon. However, to form a tin oxide film, it is preferred to employ a substrate of e.g. glass, quartz glass, silica film-attached glass, plastic or a silicon wafer. Particularly when a baking temperature is taken into account, glass, quartz glass, silica film-attached glass, a silicon wafer or the like, is preferred.

Drying of the coating film formed on the substrate may be carried out at a temperature within a range of from room temperature to 150°C, preferably from 50 to 100°C. If the temperature is lower than room temperature, not only it takes time for drying the coating film, but also mixing of the dried film with a resist is likely to take place during the coating of the resist in the subsequent step, whereby it tends to be difficult to obtain a good pattern. At a temperature higher than 150°C, the solubility in the alkaline developing solution is likely to be poor, and a residual film tends to remain at the etching portion, whereby it tends to be difficult to obtain a good pattern.

For the baking of the pattern film in the present invention, a usual heating method may be employed, for example, a hot plate, an oven, a belt furnace or a muffle furnace. The baking temperature is preferably at least 350°C, particularly preferably at least 500°C. At a temperature lower than 350°C, crystallization of the tin oxide film tends to be inadequate, and it tends to be difficult to obtain a highly electroconductive film. The baking time is preferably at least 10 minutes, particularly preferably at least 30 minutes. If it is shorter than 10 minutes, crystallization and densification of the tin oxide film tend to be inadequate, whereby it will be difficult to obtain a highly electroconductive dense film. Further, the baking atmosphere may be changed to e.g. an oxygen atmosphere, a nitrogen atmosphere or a reducing atmosphere, as the case requires.

In the present invention, when ultraviolet rays are irradiated to the pattern film before baking, densification of the film will be accelerated, and the resistance tends to be low, and in some cases, ultraviolet rays may be irradiated.

### EXAMPLES

### EXAMPLE 1

Into a 200 ml eggplant type flask, 40.5 g of hexylene glycol, 11.6 g of butyl cellosolve, 5.8 g of propylene glycol monobutyl ether, 42.1 g of tin(II) octylate and 3.0 g of antimony(III) acetate were sequentially added and stirred for 30 minutes to obtain a solution. The solid content of the solution was 15 wt%, as calculated as tin (IV) oxide.

A few drops of this solution were dropped on a silica (SiO₂) film-coated glass substrate and spin-coated at a rotational speed of 2,000 rpm for 20 seconds and dried at 80°C for 5 minutes on a hot plate (Fig. 1). Then, via a pattern mask, ultraviolet rays were irradiated for 3 minutes by a high pressure mercury lamp of 1,000 W. The intensity of ultraviolet rays was 140 mW/cm² at 350 nm (Fig. 2). Then, the dried film was subjected to etching of the unexposed portion by immersion in an alkaline developing solution (NMD-3, manufactured by Tokyo Ouka Kogyo K.K.) to form a pattern (Fig. 3). Then, it was dried at 100°C for 5 minutes in an oven and baked at 550°C for one hour in air by an electric furnace to obtain a pattern film of an antimony oxide-doped tin(IV) oxide (Fig. 4).

This substrate was observed by an optical microscope, whereby a good pattern with a line/space=80 µm/220 µm, was obtained. The film thickness of this antimony oxide-doped tin(IV) oxide (as measured by a Talystep manufactured by Rank Taylor Hobson Company) was 1,000 Å, and the line resistance was 10 kΩ/□.

### EXAMPLE 2

Into a 300 ml eggplant type flask, 90 g of ethanol, 90 g of butyl cellosolve, 1.0 g of hydrogen fluoride and 100 g of tin(II) octylate were sequentially added and stirred for 30 minutes to obtain a solution. The solid content of the solution was 13 wt%, as calculated as tin (IV) oxide.

This solution was formed into a film, exposed and subjected to etching of the non-exposed portion by an alkaline developing solution, in the same manner as in Example 1, to obtain a pattern film. This film was subjected to irradiation with ultraviolet rays and baking to obtain a pattern film of a fluorine-doped tin(IV) oxide.

This substrate was observed by an optical microscope, whereby a good pattern with a line/space=80 µm/220 µm, was obtained. The film thickness of this fluorine-doped tin(IV) oxide was 1,000 Å, and the line resistance was 100 kΩ/□.

### INDUSTRIAL APPLICABILITY

In the present invention, an attention has been drawn to a method for patterning a tin(IV) oxide type thin film, whereby conventional etching is difficult and a good pattern is hardly obtained, and it has been discovered that the chemical resistance of the coating film will be different by irradiation with ultraviolet rays, whereby no photoresist film will be required, and the process can be simplified, and by the subsequent baking, a pattern film of a transparent electroconductive tin oxide can be obtained simply and efficiently.

It is thereby possible to use it as an electroconductive pattern film for e.g. a display touch panel. Further, it may be applied to electrodes for EL or a solar cell.

## Claims

1. A method for patterning an electroconductive tin oxide film, **characterized by** employing a solution having a tin compound and a dopant compound soluble in an organic solvent dissolved in the organic solvent, drying it to such an extent that the dried film retains the solubility in a developing solution, exposing the dried film with a light containing an ultraviolet region to render it partially insoluble, and etching the unexposed portion with the developing solution.

2. The method for patterning an electroconductive tin oxide film according to Claim 1, which comprises the following steps (A), (B) and (C):
(A) a step of forming the solution having a tin compound and a dopant compound soluble in an organic solvent dissolved in the organic solvent,
(B) a step of coating the solution obtained in step (A) on a substrate and drying a coating film formed on the substrate to form a dried film, and
(C) a step of transcribing a pattern on the dried film obtained in step (B), by a light containing an ultraviolet region, then etching the dried film constituting the transcribed pattern, with a developing solution to form a partially developed pattern film, and then baking the dried film to form a tin(IV) oxide film.

3. The method for patterning an electroconductive tin oxide film according to Claim 1 or 2, wherein the dopant compound is an antimony compound and/or a fluorine compound.

4. The method for patterning an electroconductive tin oxide film according to Claim 3, wherein the antimony compound is used in an atomic ratio of from 2 to 30 mol%, based on the tin compound.

5. The method for patterning an electroconductive tin oxide film according to Claim 3, wherein the fluorine compound is used in an atomic ratio of from 2 to 60 mol%, based on the tin compound.

6. The method for patterning an electroconductive tin oxide film according to Claim 1, 2 or 3, wherein the concentration of the tin compound and the dopant compound in the solution having them dissolved in the organic solvent, is from 2 to 30 wt% as solid content concentration.

7. The method for patterning an electroconductive tin oxide film according to Claim 1, 2 or 3, wherein the light containing an ultraviolet region is a light containing a wavelength of from 180 nm to 400 nm.

8. The method for patterning an electroconductive tin oxide film according to Claim 1, 2 or 3, wherein the developing solution is an alkaline developing solution or an acid developing solution.

9. The method for patterning an electroconductive tin oxide film according to Claim 1, 2 or 3, wherein the temperature for drying the coating film formed on the substrate is within a range of from room temperature to 150°C.

10. The method for patterning an electroconductive tin oxide film according to Claim 2 or 3, wherein the temperature for baking the dried film is at least 350°C.
